# EUROPEAN PATENT APPLICATION

(11) **EP 4 648 580 A1**
(43) Date of publication of application: **12.11.2025**
(21) Application number: 25725741.0
(22) Date of filing: 12.02.2025
(51) Int. Cl.: H10F 77/14

(54) **BACK CONTACT BATTERY AND PHOTOVOLTAIC MODULE**

(30) Priority: 14.03.2024 CN 202420494483 U
(71) Applicant: Longi Green Energy Technology Co., Ltd., Xi'an, Shaanxi 710100 (CN)
(72) Inventor: TONG, Hongbo, Xi'an, Shaanxi 710100 (CN); LI, Zhenguo, Xi'an, Shaanxi 710100 (CN); LIU, Qingping, Xi'an, Shaanxi 710100 (CN); DONG, Guangbin, Xi'an, Shaanxi 710100 (CN); DING, Chao, Xi'an, Shaanxi 710100 (CN); ZHANG, Hongchao, Xi'an, Shaanxi 710100 (CN); CHEN, Chen, Xi'an, Shaanxi 710100 (CN); XU, Xinxing, Xi'an, Shaanxi 710100 (CN); WANG, Yanzeng, Xi'an, Shaanxi 710100 (CN)
(74) Representative: Pfenning, Meinig & Partner mbB
(86) International application number: PCT/CN2025/077013
(87) International publication number: WO 2025/190021

(57) **Abstract**

The present application discloses a back contact solar cell and a photovoltaic module. The back contact solar cell includes: a silicon substrate, having a front surface and a back surface opposite to the front surface; a first doped crystalline silicon region and a second doped crystalline silicon region, both arranged on the back surface of the silicon substrate, where a first surface of the first doped crystalline silicon region away from the silicon substrate and a second surface of the second doped crystalline silicon region away from the silicon substrate are both polished surfaces; and an isolation groove, configured to isolate the first doped crystalline silicon region and the second doped crystalline silicon region, where a first textured structure with pyramidal structures is arranged at a bottom of the isolation groove, a distribution density of apexes of the pyramidal structures ranging from 25/100 µm² to 80/100 µm². The back surface of the silicon substrate includes an overlapping region corresponding to the first doped crystalline silicon region and the second doped crystalline silicon region, the overlapping region being a polished surface. In embodiments of the present application, the first surface and the second surface have high flatness and low surface roughness, which is conducive to passivation, and a passivation effect of a polished surface is significantly better than a passivation effect of a textured surface.

## Description

### TECHNICAL FIELD

The present application relates to the field of photovoltaic technologies, and in particular, to a back contact solar cell and a photovoltaic module.

### BACKGROUND

A back contact solar cell is a solar cell with a positive electrode and a negative electrode located on a back surface. To achieve higher efficiency, one method is to prepare a high-efficient back contact solar cell having P-type and N-type regions using tunneling oxide layer passivation in combination with polysilicon doping.

Currently, during preparation of the foregoing back contact solar cell, texturing is usually performed first, and then, junction region treatment is performed on a back surface, to form an interdigitated back contact (BC) structure. A surface of a doped polysilicon region in the prepared back contact solar cell is a textured structure, and different doped polysilicon regions are isolated by an isolation groove.

However, that the surface of the doped polysilicon region is a textured structure causes insufficient coverage of a passivation film layer in a subsequent surface passivation procedure, resulting in a failure in forming excellent surface passivation and a poor passivation effect. In addition, when P-type and N-type doped polysilicon regions and an isolation groove are formed through an existing etching process, an isolation effect and a light trapping effect of the isolation groove are poor.

### SUMMARY

The present application provides a back contact solar cell and a photovoltaic module, aiming to resolve at least a technical problem of a poor passivation effect of a back contact solar cell in the related art.

According to a first aspect, an embodiment of the present application provides a back contact solar cell, including:
a silicon substrate, having a front surface and a back surface opposite to the front surface;
a first doped crystalline silicon region and a second doped crystalline silicon region, both arranged on the back surface of the silicon substrate, where a first surface of the first doped crystalline silicon region away from the silicon substrate and a second surface of the second doped crystalline silicon region away from the silicon substrate are both polished surfaces; and
an isolation groove, configured to isolate the first doped crystalline silicon region and the second doped crystalline silicon region, where a first textured structure with pyramidal structures is arranged at a bottom of the isolation groove, a distribution density of apexes of the pyramidal structures ranging from 25/100 µm² to 80/100 µm².

The back surface of the silicon substrate includes an overlapping region corresponding to the first doped crystalline silicon region and the second doped crystalline silicon region, the overlapping region being a polished surface.

In an embodiment, along a thickness direction of the back contact solar cell, a distance between the first surface of the first doped crystalline silicon region away from the silicon substrate and the bottom of the isolation groove ranges from 3 µm to 6 µm.

In an embodiment, along a thickness direction of the back contact solar cell, a distance between the second surface of the second doped crystalline silicon region away from the silicon substrate and the bottom of the isolation groove ranges from 1 µm to 5 µm.

In an embodiment, a plurality of isolation grooves are provided. Along a distribution direction of the plurality of isolation grooves, a width of the isolation grooves ranges from 20 µm to 150 µm.

In an embodiment, the isolation groove extends into the silicon substrate. A depth by which the isolation groove extends into the silicon substrate ranges from 2.5 µm to 5.8 µm.

In an embodiment, a thickness of the first doped crystalline silicon region ranges from 100 nm to 500 nm. A thickness of the second doped crystalline silicon region ranges from 100 nm to 500 nm.

In an embodiment, a cross-sectional shape of the isolation groove is rectangular or trapezoidal.

In an embodiment, a tunneling oxide layer is further included. The tunneling oxide layer is located between the silicon substrate and the first doped crystalline silicon region, and is located between the silicon substrate and the second doped crystalline silicon region. A thickness of the tunneling oxide layer ranges from 0.5 nm to 3 nm.

In an embodiment, a second textured structure with pyramidal structures is arranged on the front surface of the silicon substrate.

According to a second aspect, an embodiment of the present application provides a photovoltaic module, including the back contact solar cell according to any one of the foregoing.

In an embodiment of the present application, the first surface and the second surface are both polished surfaces. To be specific, the first surface and the second surface are both non-textured structures. The first surface and the second surface have high flatness and low surface roughness, which is conducive to passivation. A passivation effect of a polished surface is significantly better than a passivation effect of a textured surface, which enhances surface passivation performance of a PN junction region in a finally formed back contact solar cell. In addition, the polished surfaces can provide better protection and barrier effects during alkaline etching, thereby enhancing etching barrier performance, so that structures of the formed first doped crystalline silicon region and the formed second doped crystalline silicon region are denser. In addition, after the passivation effect is improved, a specific voltage gain can be obtained, thereby improving efficiency of the back contact solar cell.

In addition, in a same wet etching process, when a distribution density of apexes of the pyramidal structures ranges from 25/100 µm² to 80/100 µm², a depth of the finally formed isolation groove is large, which implements effective isolation between the first doped crystalline silicon region and the second doped crystalline silicon region, thereby reducing a short-circuit leakage risk of the PN junction region. In addition, when the distribution density of the apexes of the pyramidal structures at the bottom of the isolation groove ranges from 25/100 µm² to 80/100 µm², a good light trapping effect is achieved, which is conducive to improving efficiency of the solar cell. The foregoing description is only an overview of technical solutions of the present application. To understand the technical means of the present application more clearly, implementation can be performed based on content of the specification. In addition, to make the foregoing and other objectives, features, and advantages of the present application more comprehensible, specific embodiments of the present application are specifically listed below.

### BRIEF DESCRIPTION OF THE DRAWINGS

FIG. 1 is a schematic structural diagram of a back contact solar cell according to an embodiment of the present application;
FIG. 2 is a schematic structural diagram of an intermediate member 1 in a process of preparing a back contact solar cell;
FIG. 3 is a schematic structural diagram of an intermediate member 2 in a process of preparing a back contact solar cell;
FIG. 4 is a schematic structural diagram of an intermediate member 3 in a process of preparing a back contact solar cell;
FIG. 5 is a schematic structural diagram of an intermediate member 4 in a process of preparing a back contact solar cell; and
FIG. 6 is a schematic structural diagram of an intermediate member 5 in a process of preparing a back contact solar cell.

### Reference signs:

10-silicon substrate, 11-back surface, 111-overlapping region, 12-front surface, 121-second textured structure, 20-tunneling oxide layer, 30-first doped crystalline silicon region, 31-first surface, 40-second doped crystalline silicon region, 41-second surface, 50-isolation groove, 51-first textured structure, 60-polysilicon layer, 70-boron-doped polysilicon, 80-phosphorus-doped polysilicon, and 90-laser.

### DETAILED DESCRIPTION

The following describes exemplary embodiments of the present application in further detail with reference to the accompanying drawings. Although exemplary embodiments of the present application are shown in the accompanying drawings, it should be understood that, the present application can be implemented in various manners and should not be limited by the embodiments described herein. On the contrary, embodiments are provided, so that the present application can be understood more thoroughly and a scope of the present application can be completely conveyed to a person skilled in the art.

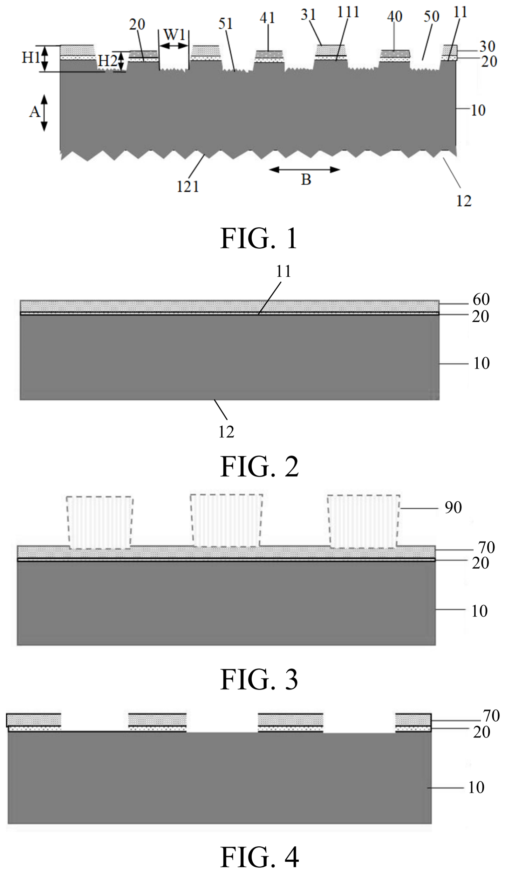

According to a first aspect, referring to FIG. 1, an embodiment of the present application discloses a back contact solar cell, including:
a silicon substrate 10, having a front surface 12 and a back surface 11 opposite to the front surface 12;
a first doped crystalline silicon region 30 and a second doped crystalline silicon region 40, both arranged on the back surface 11 of the silicon substrate 10, where a first surface 31 of the first doped crystalline silicon region 30 away from the silicon substrate 10 and a second surface 41 of the second doped crystalline silicon region 40 away from the silicon substrate 10 being both polished surfaces; and
an isolation groove 50, configured to isolate the first doped crystalline silicon region 30 and the second doped crystalline silicon region 40, where a first textured structure 51 with pyramidal structures is arranged at a bottom of the isolation groove 50, a distribution density of apexes of the pyramidal structures ranging from 25/100 µm² to 80/100 µm².

The back surface 11 of the silicon substrate 10 includes an overlapping region 111 corresponding to the first doped crystalline silicon region 30 and the second doped crystalline silicon region 40. The overlapping region 111 is a polished surface.

It should be noted that that the foregoing distribution density of the apexes of the pyramidal structures is 25/100 µm² means that 25 apexes are distributed on every 100 µm² of the bottom of the isolation groove. That the foregoing distribution density of the apexes of the pyramidal structures is 80/100 µm² means that 80 apexes are distributed on every 100 µm² of the bottom of the isolation groove.

Specifically, the silicon substrate 10 is an N-type monocrystalline silicon wafer or a P-type monocrystalline silicon wafer. The back surface 11 of the silicon substrate 10 is a back surface, and the front surface 12 of the silicon substrate 10 is a light receiving surface. The first doped crystalline silicon region 30 and the second doped crystalline silicon region 40 both include polysilicon. The first doped crystalline silicon region 30 is a P-type doped crystalline silicon region. The P-type doped crystalline silicon region includes boron. A concentration of the boron ranges from 3×10¹⁸/cm³ to 3×10²⁰/cm³. The second doped crystalline silicon region 40 is an N-type doped crystalline silicon region. The N-type doped crystalline silicon region includes phosphorus. A concentration of the phosphorus ranges from 2× 10²⁰ /c m³ to 2×10²¹/cm³.

During preparation of the back contact solar cell, a tunneling oxide layer 20 and a polysilicon layer 60 can be first deposited on the back surface 11 of the silicon substrate 10, and then the polysilicon layer 60 is doped with boron, to form boron-doped polysilicon 70. After procedures such as laser processing and chemical etching, the first doped crystalline silicon region 30 is finally formed. The polysilicon layer 60 can be deposited through a process such as chemical vapor deposition (CVD) or low-pressure chemical vapor deposition (LPCVD). Before deposition of the polysilicon layer 60 on the back surface of the silicon substrate 10, alkaline polishing is first performed on the silicon substrate 10, to smoothen and clean the surface of the silicon substrate 10. In this way, the back surface 11 of the silicon substrate 10 is already a polished surface before the deposition of the polysilicon layer 60, so that the overlapping region 111 in the back surface 11 is a polished surface. The overlapping region 111 is specifically a region that is in contact with the tunneling oxide layer 20 and that is in the back surface 11 in FIG. 1. During the alkaline polishing, an alkaline solution with an alkaline concentration of 10% to 40% can be used.

The first surface 31 and the second surface 41 are both polished surfaces. To be specific, the first surface 31 and the second surface 41 are both non-textured structures. The first surface 31 and the second surface 41 have high flatness and low surface roughness, which is conducive to passivation. A passivation effect of a polished surface is significantly better than a passivation effect of a textured surface, which enhances surface passivation performance of a PN junction region in a finally formed back contact solar cell. In addition, the polished surfaces can provide better protection and barrier effects during alkaline etching, thereby enhancing etching barrier performance, so structures of the formed first doped crystalline silicon region 30 and the formed second doped crystalline silicon region 40 are denser. In addition, after the passivation effect is improved, a specific voltage gain can be obtained, thereby improving efficiency of the back contact solar cell.

The isolation groove 50 is located between the first doped crystalline silicon region 30 and the second doped crystalline silicon region 40, and is configured to isolate the first doped crystalline silicon region 30 and the second doped crystalline silicon region 40. The distribution density of the apexes of the pyramidal structures ranging from 25/100 µm² to 80/100 µm² is specifically 25/100 µm², 30/100 µm², 40/100 µm², 50/100 µm², 70/100 µm², 80/100 µm², or the like. In an embodiment of the present application, in a same wet etching process, when a distribution density of apexes of pyramidal structures in the first textured structure 51 is large, a depth of the finally formed isolation groove 50 is large, which implements effective isolation between the first doped crystalline silicon region 30 and the second doped crystalline silicon region 40, thereby reducing a short-circuit leakage risk of the PN junction region. In addition, when the distribution density of apexes of the pyramidal structures at the bottom of the isolation groove ranges from 25/100 µm² to 80/100 µm², a good light trapping effect is achieved, which is conducive to improving efficiency of the solar cell.

A wet etching process is used to form the isolation groove 50. An etching solution used in the wet etching process includes alkali and an auxiliary additive. A concentration of the alkali ranges from 2% to 15%, and the alkali is specifically potassium hydroxide, sodium hydroxide, or the like. A volume ratio of the auxiliary additive ranges from 0.5% to 4%, and components of the auxiliary additive include sodium benzoate, a defoaming agent, a surfactant, and the like. The auxiliary additive functions to protect a region not scanned by laser.

Along a thickness direction of the back contact solar cell, a distance between the first surface 31 of the first doped crystalline silicon region 30 away from the silicon substrate 10 and the bottom of the isolation groove 50 ranges from 3 µm to 6 µm.

Specifically, for the thickness direction of the back contact solar cell, reference can be made to a direction shown by an arrow in FIG. 1. For the distance between the first surface 31 and the bottom of the isolation groove 50, reference can be made to H1 shown in FIG. 1. The distance H1 between the first surface 31 and the bottom of the isolation groove 50 ranges from 3 µm to 6 µm, and is specifically 3 µm, 3.5 µm, 4 µm, 4.5 µm, 5 µm, 5.5 µm, 6 µm, or the like. When the distance between the first surface 31 of the first doped crystalline silicon region 30 and the bottom of the isolation groove 50 falls within the foregoing range, a depth of the isolation groove 50 can be ensured, thereby better isolating the first doped crystalline silicon region 30 and the second doped crystalline silicon region 40.

Along a thickness direction of the back contact solar cell, a distance between the second surface 41 of the second doped crystalline silicon region 40 away from the silicon substrate 10 and the bottom of the isolation groove 50 ranges from 1 µm to 5 µm.

Specifically, for the distance between the second surface 41 and the bottom of the isolation groove 50, reference can be made to H2 shown in FIG. 1. The distance H2 between the second surface 41 and the bottom of the isolation groove 50 ranges from 1 µm to 5 µm, and is specifically 1 µm, 1.5 µm, 2 µm, 2.5 µm, 3 µm, 3.5 µm, 4 µm, 4.5 µm, 5 µm, or the like. When the distance between the second surface 41 of the second doped crystalline silicon region 40 and the bottom of the isolation groove 50 falls within the foregoing range, a depth of the isolation groove 50 can be ensured, thereby better isolating the first doped crystalline silicon region 30 and the second doped crystalline silicon region 40.

A plurality of isolation grooves 50 are provided. Along a distribution direction of the plurality of isolation grooves 50, a width of the isolation grooves 50 ranges from 20 µm to 150 µm.

Specifically, for an arrangement direction of the plurality of isolation grooves 50, reference can be made to a direction shown by an arrow B in FIG. 1. For a width of the isolation grooves 50, reference can be made to W1 shown in FIG. 1. The width W1 of the isolation grooves 50 is specifically a width of bottoms of the isolation grooves 50. The width W1 of the isolation grooves 50 ranges from 20 µm to 150 µm, and is specifically 20 µm, 25 µm, 30 µm, 39 µm, 45 µm, 50 µm, 55 µm, 60 µm, 63 µm, 70 µm, 80 µm, 90 µm, 100 µm, 110 µm, 120 µm, 130 µm, 140 µm, 150 µm, or the like. When the width of the isolation grooves 50 falls within the foregoing range, effective isolation between the first doped crystalline silicon region 30 and the second doped crystalline silicon region 40 can be ensured.

The isolation groove 50 extends into the silicon substrate 10. In addition, a depth by which the isolation groove 50 extends into the silicon substrate 10 ranges from 2.5 µm to 5.8 µm.

Specifically, the depth by which the isolation groove 50 extends into the silicon substrate 10 is specifically a distance between the bottom of the isolation groove 50 and the back surface 11 of the silicon substrate 10 along the thickness direction of the back contact solar cell. A depth by which the isolation groove 50 extends into the silicon substrate 10 ranges from 2.5 µm to 5.8 µm, and is specifically 2.5 µm, 3 µm, 3.5 µm, 4 µm, 4.5 µm, 5 µm, 5.8 µm, or the like. When the depth by which the isolation groove 50 extends into the silicon substrate 10 falls within the foregoing range, the depth of the isolation groove 50 can be ensured, thereby better isolating the first doped crystalline silicon region 30 and the second doped crystalline silicon region 40.

A thickness of the first doped crystalline silicon region 30 ranges from 100 nm to 500 nm. A thickness of the second doped crystalline silicon region 40 ranges from 100 nm to 500 nm. The thickness of the second doped crystalline silicon region 40 is equal to or not equal to the thickness of the first doped crystalline silicon region 30.

A cross-sectional shape of the isolation groove 50 is rectangular or trapezoidal. A cross-sectional shape of the isolation groove 50 is trapezoidal in an embodiment. A cross section of the isolation groove 50 specifically refers to a cross section perpendicular to an extension direction of the isolation groove 50. When the cross-sectional shape of the isolation groove 50 is rectangular or trapezoidal, the shape is simple, leading to easy preparation.

The back contact solar cell provided in an embodiment of the present application further includes a tunneling oxide layer 20. The tunneling oxide layer 20 is located between the silicon substrate 10 and the first doped crystalline silicon region 30, and is located between the silicon substrate 10 and the second doped crystalline silicon region 40. A thickness of the tunneling oxide layer 20 ranges from 0.5 nm to 3 nm.

Specifically, during preparation of the back contact solar cell, the tunneling oxide layer 20 is first deposited on the back surface 11 of the silicon substrate 10, and a polycrystalline silicon layer 60 is then deposited. A thickness of the tunneling oxide layer 20 is specifically 0.5 nm, 1 nm, 1.2 nm, 1.8 nm, 2.5 nm, 3 nm, or the like.

A second textured structure 121 with pyramidal structures is arranged on the front surface 12 of the silicon substrate 10.

Specifically, during preparation, acid etching is first performed on the front surface 12 of the silicon substrate 10, to remove an oxide layer on the front surface 12. After the oxide layer is removed, the second textured structure 121 is formed by using a wet etching process. Arrangement of the second textured structure 121 can reduce reflectivity of the front surface 12 of the silicon substrate 10.

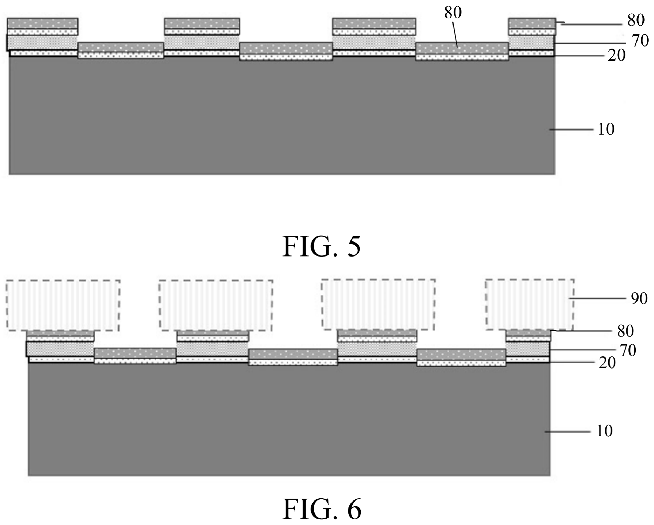

A specific process of preparing a back contact solar cell according to an embodiment of the present application is, for example:
S1: Provide a silicon substrate 10. The silicon substrate 10 is an N-type monocrystalline silicon wafer or a P-type monocrystalline silicon wafer.
S2: Polish the silicon substrate 10. Specifically, the silicon substrate 10 is polished by using an alkaline solution having an alkaline concentration of 10% to 40%, to smoothen and clean the surface of the silicon substrate 10.
S3: Deposit a tunneling oxide layer 20 and a polysilicon layer 60 on the polished silicon substrate 10. For a structure after the deposition, reference can be made to an intermediate member 1 shown in FIG. 2. A thickness of the deposited tunneling oxide layer 20 ranges from 0.5 nm to 3 nm, and a thickness of the deposited polysilicon layer 60 ranges from 100 nm to 500 nm.
S4: Dope the deposited polysilicon layer 60. A doped element is not limited to an accepter impurity and a donor impurity such as boron and phosphorus, and a doping concentration of the boron ranges from 3× 10¹⁸/c m³ to 3× 10²⁰ /c m³, and a doping concentration of the phosphorus ranges from 2×2×10²⁰/cm³ to 2×10²¹/cm³. In this step, boron is doped in an embodiment, and boron-doped polysilicon 70 is formed after boron is doped.
S5: Perform laser film opening. The laser film opening is patterning a surface of a specific silicon wafer by using laser energy. For a position scanned by laser 90, reference can be made to a position shown in FIG. 3. The laser 90 is obtained through a laser. The laser is a nanosecond, picosecond, or femtosecond laser. A power of the laser ranges from 10 W to 60 W, and a diameter of a laser spot ranges from 50 µm to 300 µm.
S6: Perform wet etching. A position scanned by the laser 90 is etched, and a position not scanned by the laser 90 is not etched. An etching solution used in this step includes alkali and an auxiliary additive. A concentration of the alkali ranges from 4% to 20%, and the alkali is specifically potassium hydroxide, sodium hydroxide, or the like. A volume ratio of the auxiliary additive ranges from 0.5% to 5%, and components of the auxiliary additive include sodium benzoate, a defoaming agent, a surfactant, and the like. The auxiliary additive functions to protect a region not scanned by laser, to ensure polishing of the surface. A process of the wet etching is performed in stages in different chemical solution tanks having different chemical formulas and different cleaning functions. During the wet etching, a temperature ranges from 65°C to 85°C, a process time ranges from 50s to 300s, and an etching depth ranges from 0.5 µm to 3 µm. For a structure obtained after the wet etching, reference can be made to an intermediate member 3 shown in FIG. 4. A groove is formed in the intermediate member 3.
S7: Prepare another, different type of doped polysilicon. When boron is doped in S4, phosphorus-doped polysilicon is prepared in this step. During preparation of the phosphorus-doped polysilicon, a tunneling oxide layer and a polysilicon layer are deposited again, and the polysilicon layer is then doped with phosphorus, so that phosphorus-doped polysilicon 80 is prepared. A doping concentration of the phosphorus ranges from 2×10²⁰/cm³ to 2×10²¹/cm³. For a structure obtained after preparation of the another, different type of doped polysilicon region is completed, reference can be made to an intermediate member 4 shown in FIG. 5.
S8: Perform acid etching on a front surface 12 of the silicon substrate 10, to remove an oxide layer on the front surface 12.
S9: Perform laser film opening again. For a position scanned by the laser 90, reference can be made to a position shown in FIG. 6. The laser 90 is obtained through a laser. The laser is a nanosecond, picosecond, or femtosecond laser. A power of the laser ranges from 10 W to 100 W, and a diameter of a laser spot ranges from 50 µm to 350 µm.
S10: Perform wet etching on the front surface and a back surface, to form a textured surface on the front surface, form a polished surface in a doped polysilicon region of the back surface, and form a first textured structure with pyramidal structures at a bottom of an isolation groove on the back surface. A distribution density of apexes of the pyramidal structures ranges from 25/100 µm² to 80/100 µm². A position scanned by the laser 90 is etched, and a position not scanned by the laser 90 is not etched. An etching solution used for texturing and wet etching in this step includes alkali and an auxiliary additive. A concentration of the alkali ranges from 2% to 15%, and the alkali is specifically potassium hydroxide, sodium hydroxide, or the like. A volume ratio of the auxiliary additive ranges from 0.5% to 4%, and components of the auxiliary additive include sodium benzoate, a defoaming agent, a surfactant, and the like. The auxiliary additive functions to protect a region not scanned by laser, to ensure polishing of the polysilicon surface. A process of the wet etching is performed in stages in different chemical solution tanks having different chemical formulas and different cleaning functions. During the wet etching, a temperature ranges from 55°C to 85°C, a process time ranges from 40s to 400s, and an etching depth ranges from 1 µm to 5 µm, to ensure a depth of the finally formed isolation groove 50 and a distribution density of apexes of the pyramidal structures at the bottom of the isolation groove 50. For a structure obtained after the wet etching in S10, reference can be made to a structure shown in FIG. 1.
S11: Perform subsequent surface passivation and metallization procedures, to prepare a back contact solar cell.

According to a second aspect, an embodiment of the present application further provides a photovoltaic module, including the back contact solar cell according to any one of the foregoing. Because the photovoltaic module includes the foregoing back contact solar cell, the photovoltaic module also has beneficial effects of the foregoing back contact solar cell. Details are not described herein again.

It should be noted that terms "include", "comprise", and any variants thereof are intended to cover a non-exclusive inclusion. Therefore, in the context of a process, method, object, or apparatus that includes a series of elements, the process, method, object, or apparatus not only includes such elements, but also includes other elements not specified expressly, or may include inherent elements of the process, method, object, or device. Without more limitations, elements defined by a sentence "including one" does not exclude that there are still other same elements in the process, method, object, or apparatus.

Although embodiments of the present application have been described above with reference to the accompanying drawings, the present application is not limited to the specific implementations described above, and the specific implementations described above are merely exemplary and not limitative. A person of ordinary skill in the art may make various variations under the teaching of the present application without departing from the spirit of the present application and the protection scope of the claims, and such variations shall all fall within the protection scope of the present application.

## Claims

1. A back contact solar cell, comprising:
a silicon substrate, having a front surface and a back surface opposite to the front surface;
a first doped crystalline silicon region and a second doped crystalline silicon region, both arranged on the back surface of the silicon substrate, wherein a first surface of the first doped crystalline silicon region away from the silicon substrate and a second surface of the second doped crystalline silicon region away from the silicon substrate are both polished surfaces; and
an isolation groove, configured to isolate the first doped crystalline silicon region and the second doped crystalline silicon region, wherein a first textured structure with pyramidal structures is arranged at a bottom of the isolation groove, a distribution density of apexes of the pyramidal structures ranging from 25/100 µm² to 80/100 µm², wherein
the back surface of the silicon substrate comprises an overlapping region corresponding to the first doped crystalline silicon region and the second doped crystalline silicon region, the overlapping region being a polished surface.

2. The back contact solar cell according to claim 1, wherein along a thickness direction of the back contact solar cell, a distance between the first surface of the first doped crystalline silicon region away from the silicon substrate and the bottom of the isolation groove ranges from 3 µm to 6 µm.

3. The back contact solar cell according to claim 1, wherein along a thickness direction of the back contact solar cell, a distance between the second surface of the second doped crystalline silicon region away from the silicon substrate and the bottom of the isolation groove ranges from 1 µm to 5 µm.

4. The back contact solar cell according to claim 1, wherein a plurality of isolation grooves are provided, along a distribution direction of the plurality of isolation grooves, a width of the isolation grooves ranging from 20 µm to 150 µm.

5. The back contact solar cell according to claim 1, wherein the isolation groove extends into the silicon substrate, a depth by which the isolation groove extends into the silicon substrate ranging from 2.5 µm to 5.8 µm.

6. The back contact solar cell according to claim 1, wherein a thickness of the first doped crystalline silicon region ranges from 100 nm to 500 nm; and a thickness of the second doped crystalline silicon region ranges from 100 nm to 500 nm.

7. The back contact solar cell according to claim 1, wherein a cross-sectional shape of the isolation groove is rectangular or trapezoidal.

8. The back contact solar cell according to claim 1, further comprising a tunneling oxide layer, wherein the tunneling oxide layer is located between the silicon substrate and the first doped crystalline silicon region, and is located between the silicon substrate and the second doped crystalline silicon region, a thickness of the tunneling oxide layer ranging from 0.5 nm to 3 nm.

9. The back contact solar cell according to claim 1, wherein a second textured structure with pyramidal structures is arranged on the front surface of the silicon substrate.

10. A photovoltaic module, comprising the back contact solar cell according to any one of claims 1 to 9.
